# EUROPÄISCHE PATENTSCHRIFT

(11) **EP 2 858 203 B1**
(45) Veröffentlichungstag und Bekanntmachung des Hinweises auf die Patenterteilung: **18.05.2016**
(21) Anmeldenummer: 14003318.4
(22) Anmeldetag: 25.09.2014
(51) Int. Cl.: H02J 5/00, H01R 12/61

(54) **Energieversorgungseinrichtung für explosionsgeschützte elektronische Funktionseinheiten**
Energy supply device for explosion-proof electronic functional units
Dispositif d'alimentation en énergie pour des unités de fonctionnement électroniques protégées contre les explosions

(30) Priorität: 01.10.2013 DE 202013008747 U
(43) Veröffentlichungstag der Anmeldung: 08.04.2015
(73) Patentinhaber: ABB Technology AG, 8050 Zürich (CH)
(72) Erfinder: Kretschmann, Rainer, 32549 Bad Oeynhausen (DE); Schäffer, Ralf, 32479 Hille (DE); Keul, Thomas, 63579 Freigericht (DE)
(74) Vertreter: Marks, Frank

(56) Entgegenhaltungen:
- EP-A2- 1 014 531
- WO-A1-2004/055840
- WO-A1-2011/042614
- FR-A1- 2 571 203
- US-A- 5 804 959
- US-B1- 8 310 329

## Beschreibung

Die Erfindung betrifft eine Energieversorgungseinrichtung für explosionsgeschützte elektronische Funktionseinheiten.

Derartige Energieversorgungseinrichtung werden in automatisierungstechnischen Anlagen zur Speisung von prozessnahen Komponenten und diesen zugeordneten Kommunikationseinrichtungen eingesetzt.

Aus der EP 1014531 A2 ist eine derartige Energieversorgungseinrichtung bekannt, bei der die Funktionseinheiten aus einer hochfrequenten Wechselspannung gespeist werden, die für jede der Funktionseinheiten individuell über eine Drossel ausgekoppelt wird. Es wird vorgeschlagen, die Wicklungen der Drosseln als miteinander verbundene, im Wesentlichen deckungsgleiche Leiterbahnen einer Mehrebenenleiterplatte auszubilden, wie sie prinzipiell aus der JP 62154609 A1 bekannt sind. Darüber hinaus wird vorgeschlagen, die erforderliche Induktivität der Drosseln durch Ferritkerne herbeizuführen, die durch Öffnungen in der Mehrebenenleiterplatte hindurchragen. Bei Auslegung der Drossel mit Feritkern müssen zusätzliche Maßnahmen ergriffen werden, die verhindern, dass der Ferritkern nicht seine Position verändert und/oder bricht. Ein zusätzlicher Luftspalt oder eine Positionsänderung des Kernes verändern die Induktivität der Drossel und können dadurch den Explosionschutz negativ beeinträchtigen.

Dieser Anordnung ist mit mehrere Nachteilen behaftet. Zur Aufnahme der Ferritkerne sind Ausnehmungen in die Mehrebenenleiterplatte einzubringen. Durch die Vielzahl der Ausnehmungen und ihre Bestückung mit jeweils zwei Ferritkernhälften ist der Hestellungsaufwand für die Mehrebenenleiterplatte sehr hoch. Zur Einhaltung der gemäß Explosionschutznorm geforderten Isolationsabsände ist eine Mindestplatinenfläche sowie mehrfache Metalisierungsebenen (Layer) für die Drosseln erforderlich. Weiterhin ist zum Erreichen der erforderlichen Induktivität der Drosseln eine Mehrebenenleiterplatte mit mindestens sechs Metallisierungsebenen erforderlich, während für die restliche Verdrahtung vier Metallisierungsebenen genügen. Schließlich begrenzt die Fläche der Drosseln innerhalb der Mehrebenenleiterplatte die Anzahl der anschaltbaren Funktionseinheiten.

Der Erfindung liegt daher die Aufgabe zugrunde, die Nachteile des Standes der Technik zu überwinden und eine wechselspannungsspeisende Energieversorgungseinrichtung für explosionsgeschützte elektronische Funktionseinheiten anzugeben, die mit geringem Aufwand eine Vielzahl von Funktionseinheiten speisen kann.

Erfindungsgemäß wird diese Aufgabe mit den Mitteln des Patentanspruchs 1 gelöst. Vorteilhafte Weiterbildungen der Erfindung sind in den rückbezogenen Ansprüchen angegeben.

Die Erfindung geht aus von einer Energieversorgungseinrichtung für explosionsgeschützte elektronische Funktionseinheiten, bei der die Funktionseinheiten aus einer hochfrequenten Wechselspannung gespeist werden, die für jede der Funktionseinheiten individuell über eine Drossel ausgekoppelt wird.

Erfindungsgemäß sind die Drosseln als miteinander verbundene, im Wesentlichen deckungsgleiche Leiterbahnen einer Mehrebenenleiterplatte ausgebildet und auf einer Verteilungsleiterplatte stehend angeordnet, wobei die Anzahl der Metallisierungsebenen der Mehrebenenleiterplatte größer ist als die Anzahl der Metallisierungsebenen der Verteilungsleiterplatte.

Durch die auf der Verteilungsleiterplatte stehende Anordnung der Drosseln ist deren Platzbedarf auf der Verteilungsleiterplatte viel geringer, so dass eine größere Anzahl Drosseln auf derselben Fläche der Verteilungsleiterplatte untergebracht werden. Dementsprechend mehr Funktionseinheiten sind bei gleichen Dimensionen an die Verteilungsleiterplatte anschaltbar.

Vorteilhafterweise kommt die Verteilungsleiterplatte mit einer geringen Anzahl von Metallisierungsebenen aus, so dass der Gesamtaufwand aus Verteilungsleiterplatte und zugehörigen Drosseln geringer ist als bei Unterbringung der Drosseln in der Verteilungsleiterplatte. Darüber hinaus liegen die Drosseln vor dem Einbau als separat prüfbare Einheiten vor.

Durch die vertikale Anordung der Drosseln ist es technologisch einfach die Drosseln durch Verguss fest miteinander zuverbinden und damit den Explosionschutzforderungen zugenügen.

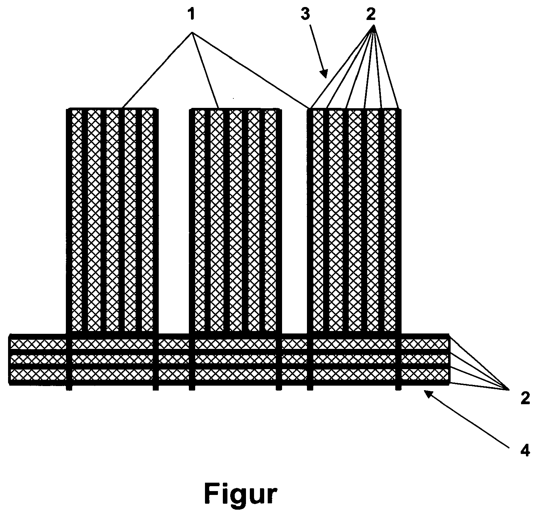

Die Erfindung wird nachstehend anhand eines Ausführungsbeispiels näher erläutert. In der einzigen Figur ist eine Energieversorgungseinrichtung für explosionsgeschützte elektronische Funktionseinheiten dargestellt, bei der die Funktionseinheiten aus einer hochfrequenten Wechselspannung gespeist werden, die für jede der Funktionseinheiten individuell über eine Drossel 1 ausgekoppelt wird. Im Einzelnen ist eine Verteilungsleiterplatte 4 mit einer Mehrzahl von Drosseln 1 vorgesehen, wobei die Drosseln 1 stehend auf der Verteilungsleiterplatte 4 angeordnet sind.

Die Drosseln 1 sind als miteinander verbundene, im Wesentlichen deckungsgleiche Leiterbahnen 2 einer Mehrebenenleiterplatte 3 ausgebildet. Dabei weist jede Metallisierungsebene der Mehrebenenleiterplatte 3 zumindest eine Windung der Drossel 1 auf. Zur Ausbildung der erforderlichen Windungszahl sind in der gezeigten Ausführungsform beispielsweise sechs Metallisierungsebenen mit Leiterbahnen 2 erforderlich.

Die Drosseln 1 sind auf der Verteilungsleiterplatte 4 mechanisch befestigt und elektrisch kontaktiert. Dazu weist die Verteilungsleiterplatte 4 mehrere Ebenen von Leiterbahnen 2 auf. Der Bedarf an Metallisierungsebenen der Verteilungsleiterplatte 4 ist jedoch geringer als bei der Mehrebenenleiterplatte 3. Zur Ausbildung der erforderlichen Leiterbahnen 2 sind in der gezeigten Ausführungsform beispielsweise nur vier Metallisierungsebenen mit Leiterbahnen 2 erforderlich.

### Bezugszeichenliste

1 Drossel
2 Leiterbahn
3 Mehrebenenleiterplatte
4 Verteilungsleiterplatte

## Patentansprüche

1. Energieversorgungseinrichtung für explosionsgeschützte elektronische Funktionseinheiten, bei der die Funktionseinheiten aus einer hochfrequenten Wechselspannung gespeist werden, die für jede der Funktionseinheiten individuell über eine Drossel (1) ausgekoppelt wird,
**dadurch gekennzeichnet,**
**dass** die Drosseln (1) als miteinander verbundene, im Wesentlichen deckungsgleiche Leiterbahnen (2) einer Mehrebenenleiterplatte (3) ausgebildet und auf einer Verteilungsleiterplatte (4) stehend angeordnet sind, wobei die Anzahl der Metallisierungsebenen der Mehrebenenleiterplatte (3) größer ist als die Anzahl der Metallisierungsebenen der Verteilungsleiterplatte (4).

## Claims

1. Energy supply device for explosion-proof electronic functional units, in which the functional units are supplied from a high-frequency AC voltage which is individually output for each of the functional units via an inductor (1),
**characterized in that** the inductors (1) are in the form of substantially congruent conductor tracks (2) of a multi-level printed circuit board (3) which are connected to one another and are arranged vertically on a distribution printed circuit board (4), the number of metallization planes of the multi-level printed circuit board (3) being greater than the number of metallization planes of the distribution printed circuit board (4).

## Revendications

1. Dispositif d'alimentation en énergie pour des unités fonctionnelles électroniques protégées contre les explosions, dans lequel les unités fonctionnelles sont alimentées à partir d'une tension alternative haute fréquence qui est désaccouplée pour chacune des unités fonctionnelles individuellement par le biais d'une bobine (1),
**caractérisé en ce que**
les bobines (1) sont réalisées sous forme de pistes conductrices (2) connectées les unes aux autres, essentiellement en coïncidence, d'une carte à circuits imprimés à plusieurs plans (3) et sont disposées debout sur une carte à circuits imprimés de distribution (4), le nombre des plans de métallisation de la carte à circuits imprimés à plusieurs plans (3) étant supérieur au nombre des plans de métallisation de la carte à circuits imprimés de distribution (4).
